# FASCICULE DE BREVET EUROPEEN

(11) **EP 2 351 048 B1**
(45) Date de publication et mention de la délivrance du brevet: **03.01.2018**
(21) Numéro de dépôt: 09761925.8
(22) Date de dépôt: 08.06.2009
(51) Int. Cl.: H01B 1/04, H01L 51/00, H01B 1/14

(54) **FIBRES A CONDUCTIVITE ELECTRIQUE POUR SYSTEMES BIOELECTROCHIMIQUES, ELECTRODES REALISEES AVEC DE TELLES FIBRES ET SYSTEMES COMPORTANT UNE OU PLUSIEURS DE TELLES ELECTRODES**
ELEKTRISCH LEITFÄHIGE FASERN FÜR BIOELEKTROCHEMISCHE SYSTEME, ELEKTRODEN ENTHALTEND DIESE FASERN UND SYSTEME ENTHALTEND DIESE ELEKTRODEN
ELECTRICALLY CONDUCTIVE FIBRES FOR BIOELECTROCHEMICALLY SYSTEMS, ELECTRODES COMPRISING THE FIBRES AND SYSTEMS COMPRISING THESE ELECTRODES

(30) Priorité: 13.06.2008 FR 0853918
(43) Date de publication de la demande: 03.08.2011
(73) Titulaire: Centre National de la Recherche Scientifique, 75016 Paris (FR)
(72) Inventeur: MANO, Nicolas, F-33400 Talence (FR); POULIN, Philippe, F-33400 Talence (FR)
(74) Mandataire: Fragnaud, Aude
(86) Numéro de dépôt international: PCT/FR2009/051076
(87) Numéro de publication internationale: WO 2009/150374

(56) Documents cités:
- WO-A-2004/020453
- WO-A-2005/075663
- JOSHI, MERCHANT, WANG, SCHMIDTKE: "Amperometric Biosensors based on Redox Polymer-Carbon Nanotube-Enzyme Composites" ANALYTICAL CHEMISTRY, vol. 77, 2005, pages 3183-3188, XP002509686

## Description

L'invention concerne des fibres à conductivité électrique pour systèmes bioélectrochimiques. L'invention concerne également des électrodes réalisées avec de telles fibres et des systèmes comportant une ou plusieurs de telles électrodes.

L'invention s'applique à la réalisation de systèmes bioélectrochimiques, en particulier des systèmes biomédicaux tels que par exemple des biocapteurs enzymatiques, immunologiques, ADN, ARN et des biopiles.

### Etat de la technique antérieure.

Le carbone est un matériau de choix pour la réalisation d'électrodes. Son inertie chimique permet en effet d'explorer de grandes gammes de potentiels en électrochimie. C'est pourquoi le carbone est très largement utilisé sous diverses formes pour la réalisation de dispositifs électrochimiques : capteurs, actionneurs, piles et batteries de stockage. De plus le carbone a la particularité d'être un matériau sur lequel s'adsorbent efficacement les molécules et polymères organiques. Il est donc possible d'y absorber des polymères redox, des enzymes ou encore des polymères conducteurs pour la réalisation de dispositifs électrochimiques évolués, plus performants et sélectifs. Il est de plus biocompatible et se prête de façon idéale à la réalisation de dispositifs pour des applications biologiques.

Le carbone présente d'autres intérêts qui sont la tenue mécanique, la stabilité thermique et la possibilité d'utilisation sous forme de « fibres » (« fibre » étant définie comme un système de longueur indéfinie et de diamètre compris entre 10 nanomètre et 1 millimètre). Cette possibilité est extrêmement précieuse pour la miniaturisation de dispositifs, la réalisation de microélectrodes ou de systèmes implantables dans des organismes vivants. La mise en forme de fibres est aussi utile car c'est un moyen d'augmenter la surface accessible pour un volume donné de matériau. Dans tous dispositifs électrochimiques, la surface spécifique est critique car elle conditionne l'amplitude des réponses des dispositifs.

Compte tenu de ces différents avantages, les fibres de carbone traditionnelles ont été largement étudiées pour la réalisation de microélectrodes, de capteurs et de biopiles électrochimiques. Elles sont encore aujourd'hui le matériau le plus utilisé pour les biopiles miniaturisées et la réalisation de microélectrodes.

Cependant les performances des matériaux actuels sont encore limitées par des courants trop faibles, des absorptions peu stables ou pas assez efficaces. Par exemple dans le cas des biopiles décrites par exemple dans la publication de Heller, A., Anal. Bioabal. Chem. 2006, 385, 469-473 et dans la publication de Heller, A., Curr Opin Biotechnol 2006, 10, 664-672 ; les puissances générées sont insuffisantes pour des systèmes biomédicaux tels que l'alimentation électrique de biocapteurs implantés notamment.

L'augmentation de la densité de courant d'un biocapteur ou d'une biopile est une étape impérative pour pouvoir atteindre respectivement des limites de détection suffisantes ou des puissances de l'ordre de 2 µW.

Pour ce faire, il est nécessaire d'augmenter la surface spécifique des électrodes.

Une façon de le faire est de réaliser des matériaux avec de plus grandes surfaces spécifiques tout en conservant, voire en améliorant, les propriétés qu'apporte le carbone dans le domaine des applications bio-électrochimiques.

Les nanotubes de carbone (monoparois, double ou multiparois) sont des matériaux qui présentent des caractéristiques à priori très intéressantes pour la bioélectrochimie. Ils sont en effet constitués de carbone et présentent du fait de leur taille nanométrique une très grande surface spécifique. Cependant les nanotubes produits en masse ne sont pas structurés. Ils se présentent sous forme d'une poudre qui ne peut être utilisée en l'état pour des applications bioélectrochimiques.

Diverses approches cependant, ont été proposées pour la modification d'électrodes avec des nanotubes de carbone.

On peut citer à titre d'exemple la publication de Wang, y; Li, Q.; Hu, S., Bioelectrochemistry 2005, 65, 135-142. Les nanotubes sont déposés aléatoirement en surface de matériaux conducteurs ou noyés dans une matrice conductrice. Il est ainsi difficile d'exploiter efficacement leurs propriétés à savoir leur surface spécifique et conductivité électrique.

D'autres approchent consistent à faire croître les nanotubes sur des surfaces conductrices. On peut citer par exemple l'article de Huang, X.-J.; Im, H.-S.; Yarimaga, O.; Kim, J.-H.; Jang, D.-Y.; Lee, D.-H.; Kim, H.-S.; Choi, Y.-K., J. Electroanal. Chem. 2006, 594, 27-34 et l'article de Wang, K.; Fishman, H. A.; Dai, H.; Harris, J. S., Nano. Lett. 2006, 6, 2043-2048.

On peut citer également la réalisation de microélectrodes simples à base de fibres de nanotubes de carbone réalisées pour la détection de la nicotine adénine dinucléotide (NADH). Une description de cette application particulière est faite dans l'article de Wang, J.; Deo, R. P.; Poulin, P.; Mangey, M., J. Am. Chem. Soc. 2003, 125, (48), 14706-14707. Il s'agit d'électrodes réservées à une application non bio électrochimique et dont la réponse est limitée à la réponse intrinsèque des nanotubes de carbone.

Enfin, une autre approche a consisté à sertir des fibres de nanotubes dans une résine de façon à exploiter la section de la fibre comme élément électro-actif. Cette approche est décrite dans l'article de Viry, L.; Derré, A.; Garrigues, P.; Sojic, N.; Poulin, P.; Kuhn, A., Anal. Bioanal. Chem. 2007, 389, 499-505. Ce type d'électrode en nanotubes reste limité pour la génération de grands courants en valeur absolue compte tenu de la petite section des fibres.

On pourra en outre se reporter à l'état de la technique constitué par le document D1 de JOSHI, MERCHANT, WANG, SCHMIDTKE, intitulé «Amperometric Biosensors based on Redox Polymer-Carbon Nanotube-Enzyme Composites ». Ce document décrit la réalisation d'une électrode constituée d'une barre en carbone vitreux (GCE) dont la surface est recouverte d'une dispersion de nanotubes de carbone (NTC). Avec la technique de dépôt employée, les NTC s'orientent de manière aléatoire, et forment une surface à deux dimensions. Après séchage du dépôt de NTC, des enzymes sont apportés et se fixent sur les NTC, un polymère redox étant utilisé à cette fin.

Dans une deuxième expérience décrite, on mélange dans des NTC en dispersion, des enzymes, puis on rajoute le polymère redox de manière à former un échantillon que l'on place sur la surface de la barre en carbone vitreux, pour former une électrode.

Les électrodes formées selon les deux techniques décrites ne sont pas constituées d'une fibre en NTC. Les processus électrochimiques sur de telles électrodes sont confinés en surface des électrodes ce qui limite les courants obtenus.

Contrairement à cette technologie, il résulte de la présente invention une organisation et une orientation des NTC à l'échelle nanométrique. L'assemblage sous forme de fibres permet d'obtenir une électrode à trois dimensions qui présente de ce fait augmentation de la surface spécifique par rapport à celles de l'état de la technique.

On pourra aussi se reporter au document D2, WO 2005/075663. Ce document décrit un procédé similaire à celui décrit dans D1. En effet, le procédé décrit consiste à mélanger un composé biologique comme un biopolymère (enzyme, ADN), à un matériau nanostructuré, comme par exemple des NTC dans une solution, à mélanger la solution pour former une dispersion, et à retirer le matériau composite nanostructuré ainsi obtenu. Les nanotubes sont assemblés alors qu'ils sont recouverts de composés biologiques. Ces composés peuvent constituer des barrières isolantes pour le passage du courant entre nanotubes, ce qui est préjudiciable à une utilisation comme électrode.

Selon la présente invention, les composés biologiques sont apportés sur les nanotubes après que ceux-ci aient été assemblés sous forme de fibres. L'assemblage initial des nanotubes sous forme d'une fibre permet de maximiser l'efficacité des contacts entre nanotubes et par là la conductivité de l'électrode.

Enfin, on pourra également se reporter à l'état de la technique que constitue le document D3, WO 2004/020453. Ce document concerne une nanoparticule fonctionnelle comprenant une nanoparticule conductrice (métal) ou semiconductrice ou en NTC, et une protéine bi fonctionnelle. Les protéines décrites ont deux domaines d'activité, l'un de ces domaines est utilisé pour fixer la protéine sur le nanotube. Des applications sont décrites pour des nanoparticules métalliques ou semi conductrices. De telles nanoparticules permettent de réaliser des liaisons nanométriques pour des circuits électroniques, ou des assemblages formant des réseaux à haute intégration de nanoparticules métalliques. Cependant aucune description concernant la réalisation d'une fibre à conductivité électrique et l'utilisation d'une telle fibre pour réaliser une électrode n'est faite ni même suggérée.

En conclusion, les solutions existantes procurent des résultats non satisfaisants pour le fonctionnement de systèmes bioélectrochimiques. Avec les fibres de carbone, la surface spécifique est trop faible pour permettre d'obtenir une densité de courant suffisante et par conséquent une conductivité adaptée à des applications telles que des systèmes bioélectrochimiques tels que des biopiles ou biocapteurs.

### Invention

La présente invention a pour but de résoudre le problème de la réalisation de fibres à conductivité électrique pour des applications telles que des systèmes bioélectrochimiques comme par exemple des biocapteurs et des biopiles utilisés notamment dans des applications biomédicales.

Ce problème est résolu au moyen de fibres bioactives qui présentent une surface spécifique élevée et une conductivité permettant d'obtenir les limites de détection ou les puissances requises dans des systèmes bioélectrochimiques tels que les biocapteurs ou les biopiles.

La présente invention a plus particulièrement pour objet des fibres à conductivité électrique principalement caractérisées en ce qu'elles sont constituées de nanotubes de carbone assemblés recouverts d'un dépôt comprenant au moins un biopolymère.

Le biopolymère peut être choisi parmi les protéines naturelles ou de synthèse telles que par exemple des enzymes.

Le dépôt peut comporter en outre un ou plusieurs polymère(s) redox pour améliorer les propriétés conductrices des fibres.

Le biopolymère peut être choisi parmi les acides nucléiques par exemple l'ADN ou l'ARN.

Un autre objet de l'invention concerne le procédé de fabrication desdites fibres. Ce procédé comprend les étapes consistant à réaliser des fibres constituées de nanotubes de carbone, et à effectuer un ou plusieurs dépôt(s) sur les fibres dont un comprend au moins un biopolymère.

Le dépôt peut être effectué par trempage ou immersion des fibres dans une solution contenant au moins un biopolymère ou bien par déposition de la solution contenant au moins un biopolymère sur les fibres ou encore par électrodéposition. La déposition par exemple par badigeonnage ou pulvérisation, est particulièrement adaptée au cas où on cherche à couvrir des tronçons sélectionnés de fibres.

Le dépôt sur les fibres comprend en outre un ou plusieurs polymère(s) redox. Ce dépôt est effectué en même temps que le dépôt du ou des biopolymère (s) par la même technique que celle utilisée pour le biopolymère.

Le dépôt du ou des polymère(s) redox peut également être effectué avant le dépôt du ou des biopolymère(s) par la technique d'immersion ou d'électrodéposition ou de déposition.

Dans un exemple de réalisation, le procédé de réalisation des fibres constituées de nanotubes de carbone comprend le filage de fibres obtenues par coagulation des nanotubes à partir d'une dispersion de nanotubes dans un solvant aqueux ou organique.

Dans le cas où la coagulation des nanotubes comporte l'utilisation d'un liant, le procédé comprend également une étape de retrait du liant avant d'effectuer le dépôt.

Le retrait du liant consiste à chauffer les fibres à la température de décomposition du liant.

Pour ne pas dégrader les propriétés des nanotubes de carbone, le liant utilisé est liant dont la température de décomposition ne dépasse pas 700°C. On choisit par exemple de l'alcool polyvinylique (APV) et le chauffage des fibres est réalisé de préférence sous atmosphère inerte et à une température qui peut être comprise entre 300° C et 1100°C et qui est choisi de préférence à 600°C.

L'invention concerne également la réalisation d'électrodes en fibre de nanotubes de carbone telles que décrites précédemment. De telles électrodes sont constituées d'un tronçon de fibre en nanotubes de carbone assemblés recouverts d'un dépôt comportant au moins un biopolymère selon l'invention.

Les électrodes peuvent être constituées d'un tronçon de fibre dont une extrémité seulement comporte le dépôt de biopolymère et éventuellement d'un polymère redox.

Les électrodes telles que définies précédemment sont particulièrement adaptées à l'utilisation dans des systèmes bioélectrochimiques tels que des biopiles ou des biocapteurs.

L'amélioration des propriétés de conductivité des fibres selon la présente invention, permet la réalisation de microélectrodes, à savoir, d'électrodes constituées d'un tronçon de fibre de longueur inférieure à 5 centimètres, 1 à 3 cm par exemple et 1 à 100 micromètres de diamètre. L'amélioration de ces propriétés permet en outre l'utilisation des microélectrodes dans des systèmes biomédicaux pouvant être implantés dans le corps humain.

D'autres particularités et avantages de l'invention apparaîtront clairement à la lecture de la description qui est faite ci-après et qui est donnée à titre d'exemple illustratif et non limitatif et en regard des figures sur lesquelles :
- la figure 1 représente les courbes de densité de courant dans le cas d'une électro-réduction d'oxygène, pour une électrode en fibre de carbone classique et pour une électrode selon l'invention;
- la figure 2 représente les courbes d'évolution dans le temps de l'électro-réduction de l'oxygène pour une fibre de carbone classique et pour une fibre selon la présente invention,
- la figure 3 représente le schéma d'une biopile équipée d'électrodes selon la présente invention,
- la figure 4 représente le schéma d'un biocapteur équipé d'électrodes selon la présente invention,
- La figure 5 représente le schéma des étapes du procédé de fabrication des fibres selon l'invention.

Les fibres à conductivité électrique selon la présente invention sont des fibres qui présentent une surface spécifique très élevée par rapport aux fibres de l'état de la technique, cette surface spécifique est supérieure à 50m2/g.

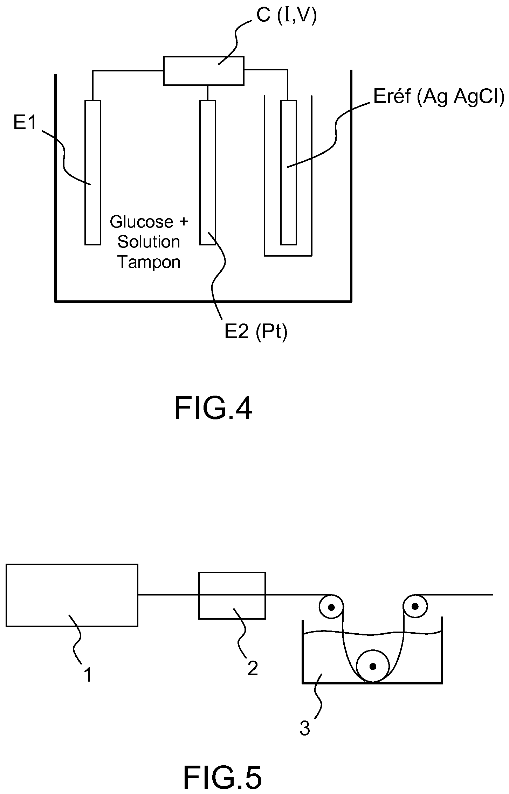

De telles fibres sont obtenues en fabriquant des fibres uniquement constituées de nanotubes de carbone assemblés : étape portant la référence 1 sur la figure 5 puis, en traitant ces fibres pour les rendre bioélectroactives : étape 3 sur la figure 5.

Ce traitement consiste à les recouvrir d'un biopolymère choisi selon les différentes applications. Les fibres obtenues sont ainsi constituées de nanotubes de carbone assemblés et un dépôt comportant au moins un biopolymère. Le dépôt peut également comporter un polymère encore dénommé polymère redox.

Le biopolymère peut être choisi parmi :
- Les protéines naturelles ou de synthèse et plus particulièrement parmi les enzymes ;
- Les acides nucléiques comme par exemple l'ADN, l'ARN.

Selon un mode de réalisation, les fibres sont par exemple obtenues à partir du procédé de fabrication décrit dans la demande de brevet WO0163028. Ce procédé permet d'obtenir des fibres qui sont uniquement constituées de nanotubes de carbone assemblés et orientés à l'échelle macroscopique par coagulation des nanotubes à partir d'une dispersion de nanotubes dans un solvant aqueux ou organique. Toutefois, les fibres obtenues par ce procédé comportent un liant qu'il est nécessaire de retirer pour les applications envisagées c'est-à-dire des applications bioélectrochimiques.

Un avantage de ce procédé est qu'il permet la fabrication de fibres à partir de nanotubes mono, double ou multi parois produits en masse.

Un autre avantage est que les fibres de nanotubes en présence de liant polymérique développées selon le procédé décrit dans cette demande de brevet WO0163028, sont suffisamment flexibles pour être pliées et nouées sans se casser, contrairement aux fibres de carbone traditionnelles.

La présence de liants qui facilitent le filage à la fabrication, limite la surface spécifique et la conductivité des fibres, c'est pourquoi, il est nécessaire pour la présente invention d'éliminer le liant afin de libérer la surface des nanotubes de carbone.

Le procédé de fabrication des fibres selon la présente invention comporte donc dans ce mode de réalisation, une étape supplémentaire, étape portant la référence 2 sur la figure 5, consistant à éliminer le liant utilisé et cela, par un traitement à haute température.

Le liant utilisé dans la fabrication de telles fibres sera choisi de sorte qu'il soit aisé de l'éliminer sans que les propriétés des nanotubes de carbone ne soient dégradées. On peut par exemple, choisir l'alcool polyvinylique (APV). Ce liant est un polymère qui assure une bonne coagulation des nanotubes dans le procédé de filage. Il peut être dégradé par un traitement thermique à partir de 300°C. Ce liant est dégradé à plus de 95% par un traitement thermique à 600°C en atmosphère non oxydante. A cette température les nanotubes ne sont aucunement dégradés.

Après ce traitement thermique, les fibres sont constituées exclusivement de nanotubes de carbone.

De préférence, l'orientation des nanotubes sera contrôlée via des étirements effectués avant le recuit thermique des fibres. Les étirements avant recuit permettent de moduler et de contrôler leur conductivité électrique ainsi que leur diamètre, leur densité et capacitance.

Ainsi, les fibres uniquement constituées de nanotubes présentent une surface spécifique très élevée, supérieure à 50m2/g. elles présentent un diamètre de 1 à 100 microns et possèdent une densité pouvant aller jusqu' à 1,8 g/cm3.

La structure de telles fibres permet une utilisation efficace des nanotubes de carbone pour des applications électrochimiques.

Le procédé de fabrication des fibres selon l'invention comporte en outre un traitement effectué en une étape ou plus, selon le type de fibres, pour les adapter aux propriétés bioélectrochimiques.

Ce traitement consiste à recouvrir les fibres d'espèces bioélectroactives (ou biospécifiques), et plus particulièrement, d'un biopolymère ou de plusieurs choisi(s). Cette étape porte la référence 3 sur la figure 5.

Le choix des biopolymères est effectué selon les applications.

Le traitement permettant de rendre les fibres bioélectroactives peut, par exemple, consister à tremper les fibres dans des solutions contenant la ou les espèce(s) requise(s) c'est-à-dire le ou les polymères choisis, ou en immergeant celles-ci avec ces solutions ou encore en procédant à une déposition de la solution sur les fibres (par exemple en les badigeonnant ou en les pulvérisant) ou bien encore en effectuant une électrodéposition de la solution sur les fibres par application d'un potentiel dans la solution.

La très forte interaction des nanotubes avec les polymères assure une stabilité d'absorption accrue. La stabilité d'absorption est critique pour la stabilité des systèmes capteurs ou biopiles. Les fibres selon l'invention garantissent ainsi une durée de fonctionnement bien supérieure à celle accessible par des matériaux carbonés traditionnels.

Pour accélérer les bio-réactions, on prévoit un deuxième traitement consistant à recouvrir les fibres du polymère redox adapté au biopolymère choisi.

De façon pratique, le dépôt du ou des polymères redox peut être effectué en même temps que le dépôt du biopolymère ou avoir été fait avant et cela par les mêmes techniques, immersion, électrodéposition, déposition.

Dans le cas d'une électrodéposition ou coélectrodéposition on pourra utiliser la méthode de Gao et al : « Electrodeposition of Redox Polymers and Co-Electrodeposition of Enzymes by CoordinativeCrosslinking », Zhiqiang Gao, Gary Binyamin, Hyug-Han Kim, Scott Calabrese Barton, Yongchao Zhang, and Adam Heller, Angew. Chem. Int. Ed. 2002, 41, No. 5, 810-813.

Le procédé pour obtenir des fibres de nanotubes de carbone peut, dans une variante de réalisation, être réalisé par coagulation sans liant polymérique selon le procédé décrit par exemple dans l'article de J. Steinmetz, M. Glerup, M. Paillet, P. Bernier, and M. Holzinger intitulée « Production of pure nanotubes fibers using a modified wet-spinning method », paru dans la publication Carbon, 43(11):2397-2400, 2005. La ou les étape(s) de traitement ultérieures des fibres de nanotubes de carbone ainsi obtenues, sont les mêmes que précédemment décrites. Cette solution présente l'avantage de ne pas nécessiter d'étape de traitement thermique pour l'élimination du liant.

Ce second mode de réalisation pourra, par exemple être réservé pour une production non continue des fibres. En effet, le filage sans liant polymérique est beaucoup plus délicat et inadapté à une production continue de fibres homogènes et de tenue mécanique suffisante.

D'autres procédés de fabrication de fibres constituées de nanotubes de carbone peuvent également être utilisés comme par exemple :
- Le procédé de coagulation utilisant un bain statique tel que décrit par L. M. Ericson, H. Fan, H. Q. Peng, V. A. Davis, W. Zhou, J. Sulpizio, Y. H ;Wang, R. Booker, J. Vavro, C. Guthy, A. N. G. Parra-Vasquez, M. J. Kim, S. Ramesh, R. K. Saini, C. Kittrell, G. Lavin, H. Schmidt, W. W. Adams,W. E. Billups, M. Pasquali, W. F. Hwang, R. H. Hauge, J. E. Fischer, and R. E. Smalley « Macroscopic, neat, single-walled carbon nanotube fibers », et publié dans Science, 305(5689):1447-1450, 2004.
- Les procédés de synthèse directs. Ils permettent la production de fibres 100% de nanotubes tels que décrits par
   - H. W. Zhu, C. L. Xu, D. H. Wu, B. Q. Wei, R. Vajtai, and P. M. Ajayan « Direct synthesis of long single-walled carbon nanotube strands » et publié dans Science, 296 (5569) : 884-886, 2002.
   - M. Zhang, K. R. Atkinson, and R. H. Baughman « Multifunctional carbon nanotube yarns by downsizing an ancient technology » et publié dans Science,306(5700):1358-1361, 2004.
   - Y. L. Li, I. A. Kinloch, and A. H.Windle « Direct spinning of carbon nanotube fibers from chemical vapor déposition synthesis » et publié dans Science, 304(5668):276-278, 2004.

Les fibres selon l'invention sont biospécificiques et présentent une grande surface spécifique, une haute conductivité électrique, et une stabilité accrue par rapport aux électrodes de l'état de la technique, elles répondent aux besoins rencontrés pour la réalisation d'électrodes dans des systèmes bioélectrochimiques.

Les caractéristiques des fibres selon l'invention sont clairement mises en évidence à partir de l'exemple de mise en oeuvre décrit ci-dessous.

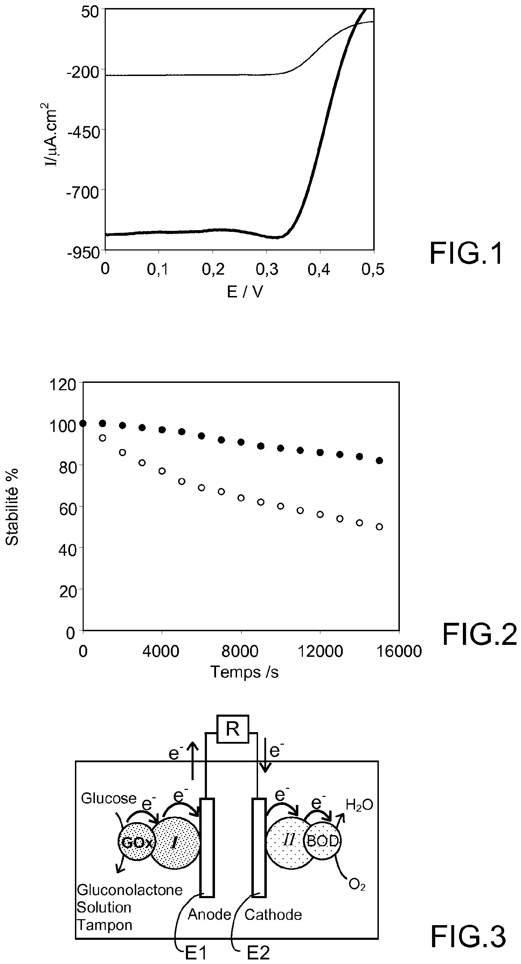

Dans cet exemple, une bioélectrocatalyse a été mise en oeuvre avec une fibre de carbone de l'état de la technique, puis avec une fibre selon l'invention. Les résultats comparatifs sont illustrés par les figures 1 et 2, les résultats relatifs à la fibre de carbone sont représentés en trait fin et ceux de la fibre conforme à l'invention sont représentés en trait épais.

### Exemple :

Dans cet exemple, une fibre de carbone traditionnelle et une fibre de nanotubes de carbone obtenue comme décrit précédemment, ont fait l'objet d'un dépôt de manière à être recouvertes d'une enzyme telle que la bilirubine oxydase et de son polymère- redox PAA-PVI-[Os(4,4'-dichloro-2,2'-bipyridine)2Cl]+/2.

Les mesures comparatives ont été effectuées en procédant à une électro-réduction de 02 sur une électrode en fibre de carbone (trait fin) et sur une électrode en fibre de nanotubes conforme à l'invention (trait épais) dans les conditions suivantes : solution avec un tampon phosphate 20 mM, 0.14 M NaCl, pH 7.2, 37.5 C, 1 mV.s-1. La composition du bioélectrocatalyseur utilisé pour recouvrir les électrodes objet de la comparaison: 32 % en poids de Bilirubine Oxydase, 60.5 % en poids de PAA-PVI-[Os (4,4'-dichloro-2,2'-bipyridine) 2Cl] +/2+, 7.5 % en poids de réticulant (poly-ethylene glycol (400) diglycidyl ether).

Comme le montre la figure 1, à +0.3 V/AgAgCl, il est possible de réduire l'O2 en H2O à une densité de courant de 880 µA.cm-2 sur l'électrode en fibre de nanotubes de carbone et seulement 215 µA.cm-2 sur une électrode en fibre de carbone. Cette valeur représente d'ailleurs la plus importante valeur reportée jusqu'ici pour la réduction d'O2 sur une fibre. Cela démontre clairement l'avantage d'utiliser des fibres de nanotubes de carbone au lieu de fibres de carbone.

En augmentant la surface spécifique de l'électrode, on augmente non seulement la densité de courant limite, mais cela permet aussi d'améliorer la cinétique enzymatique à l'électrode et de diminuer son potentiel et dans ce cas précis, de diminuer le surpotentiel de réduction de l'oxygène.

En outre, l'utilisation de fibres de nanotubes de carbone au lieu de fibre de carbone permet aussi d'augmenter la stabilité du système. Ces résultats ont été démontrés en réalisant des tests de stabilité, en milieu physiologique, en utilisant les électrodes telles que décrites précédemment.

La figure 2 illustre l'évolution dans le temps de l'électro-réduction de 02 sur l'électrode en fibre de carbone (cercles blancs) et sur l'électrode en fibre de nanotubes de carbone conforme à l'invention (cercles noirs) dans les conditions suivantes : une solution tampon phosphate 20 mM, 0.14 M NaCl, pH 7.2, 37.5 C, 1 mV.s-1. Composition du bioélectrocatalyseur : 32 % en poids de Bilirubine Oxydase, 60.5 % en poids de PAA-PVI-[Os (4,4'-dichloro-2,2'-bipyridine) 2Cl] +/2+, 7.5 % en poids de réticulant (poly-ethylene glycol (400) diglycidyl ether).

Comme l'illustre la Figure 2, après 4 heures d'opération en continue, la densité de courant a diminué de 50 % avec l'électrode en fibre de carbone, mais de seulement de 15 % avec l'électrode en fibre de nanotubes de carbone conforme à l'invention.

Avec de telles électrodes en fibre de nanotubes de carbone, il est possible de réaliser des biopiles selon des concepts classiques comme cela est illustré par le schéma de la figure 3.

Sur le schéma de la figure 3, l'anode et la cathode sont des électrodes obtenues à partir de fibres de nanotubes de carbone comme décrit précédemment. Ces électrodes sont constituées de fibres de nanotubes de carbone recouvertes de leurs bioélectrocatalyseurs respectifs et résident dans la même solution. Les électrodes sont connectées à un composant R et permettent de fournir une alimentation électrique à ce composant grâce aux réactions suivantes :
A l'anode, les électrons sont transférés du glucose vers la glucose oxydase (GOx), de la GOx vers le polymère redox I et du polymère redox I, vers l'électrode. A la cathode, les électrons sont transférés de la cathode vers le polymère redox II, du polymère redox II vers la bilirubine oxydase (BOD) et de BOD vers l'O2.

Dans le système illustré sur ce schéma, après oxydation du glucose en δ-gluconolactone par la glucose oxydase (GOx), les électrons sont transportés vers l'anode par le polymère rédox I. (Equation 1) Les électrons sont ensuite transportés de la cathode vers la bilirubine oxydase (BOD) par le polymère redox II, qui catalyse alors la réduction de l'O2 en eau (Equation 2) . L'équation 3 représente la réaction globale de la pile.

β-D-glucose → δ-gluconolactone + 2H+ + 2e- (1)

02 + 4H+ + 4e- → 2 H2O (2)

2 β-D-glucose + O2 → 2 δ-gluconolactone + H2O (3)

Une fois implantée dans le corps humain, une biopile telle que décrite peut produire quelques microwatts et peut alimenter un biodétecteur-émetteur autonome R, qui enregistre, par exemple, la concentration locale en glucose, appropriée pour la gestion du diabète ou la température locale, témoin de l'infection d'une blessure interne après chirurgie ou microchirurgie.

A titre d'exemple une expérience réalisée avec une telle biopile en présence d'air et de 15 mM de glucose a permis d'obtenir une puissance de 600 µW.cm⁻². Dans les mêmes conditions expérimentales, une biopile faite avec des fibres de carbone a permis d obtenir une puissance de seulement 180 µW. cm⁻².

Le schéma de la figure 4 illustre l'application de l'invention à la réalisation d'un biocapteur. Le biocapteur comporte trois électrodes, une anode E1, une contre électrode E2 et une électrode de référence E_{réf}. L'anode E1 est constituée de fibres de nanotubes de carbone comportant un dépôt de bioélectrocatalyseur c'est à dire du biopolymère et du polymère redox choisi. Cette anode réside dans une solution d'espèces chimiques adaptées pour la mesure effectuée. La cathode est l'électrode de référence E_{réf}, c'est-à-dire l'électrode portée à un potentiel fixe plongée dans une solution tampon. Si on utilise le même bioélectrocatalyseur que dans l'exemple donné pour les réactions figure 3, la mesure du potentiel de l'anode par rapport à celui de la cathode donne une information sur la présence et la quantité de glucose.

Les électrodes E1, E2 et E_{réf} sont connectées à un composant C de type capteur ou détecteur (potentiostat), qui permet d'effectuer une mesure de courant ou de tension résultant de la bioélectrocatalyse.

Les fibres selon l'invention trouvent des applications dans tous systèmes bioélectrochimiques.

La liste ci-dessous est donnée à titre d'exemple non limitatif pour illustrer des enzymes pouvant être choisis selon l'application désirée. On a également associé à chaque enzyme, un substrat pour la réalisation d'une biopile ou d'un biocapteur:
*1-- Glucose Oxydase* / *glucose (ou tous sucres étant oxydés par cette enzyme)*
*2-- Lactate oxydase* / *lactate*
*3-- Pyruvate oxydase* / *Pyruvate*
*4-- Alcool Oxydase* / *Alcool*
*5-- Cholestérol oxydase* / *cholestérol*
*6-- glutamate oxydase*/ *glutamate*
*7-- Pyranose oxydase*/ *pyranose*
*8--choline oxydase*/ *choline*
*9-- Cellobiose déshydrogénase* / *cellobiose*
*10-- glucose déshydrogénasse* / *glucose*
*11--Pyranose déshydrogénasse* / *pyranose*
*12-- Fructose déshydrogénase* / *fructose*
*13-- Aldéhyde oxydase* / *aldéhyde*
*14--gluconolactone oxydase* / *glucunolactone*
*15-- Alcool déshydrogénase* / *alcool*
*16--Bilirubine oxydase* / *oxygène*
*17- Laccase* / *oxygène*
*18--ceruloplasmine* / *oxygène*
*19- ascorbate oxydase* / *oxygène ou ascorbate,*
*20- horseradish peroxidase*/*H₂O₂*

Les fibres selon l'invention peuvent être fabriquées en continue. Leur section peut être circulaire ou non, et la plus grande dimension de la section peut être comprise entre 10nm et 1mm.

Tout type de nanotubes est utilisable pour leur fabrication.

Le dépôt du biopolymère peut être effectué par immersion ou trempage dans une solution comprenant le biopolymère désiré (enzyme ou ADN ou ARN), ou par électrodéposition, l'électrodéposition se faisant de manière connue par application d'un potentiel électrique à la solution.

Dans les cas où un polymère redox est utilisé pour accélérer le processus de conduction, ce polymère redox peut être dans la même solution que le biopolymère, le polymère redox est alors déposé en même temps que le polymère ou co-électrodéposé. A titre d'exemple les concentrations de polymère et biopolymères peuvent aller de 0,1mg/ml à 10 mg/ml et l'épaisseur du dépôt de biopolymère peut aller de quelque angstrôm à quelques micromètres.

Les concentrations de polymère sont choisies de manière à avoir un contrôle de l'épaisseur du dépôt et plus précisément de la quantité de biopolymère déposé.

La réalisation d'électrodes à partir de telles fibres consiste à découper des tronçons de fibres, à la longueur désirée. On peut disposer ainsi de n'importe quelle longueur.

Dans la plus part des applications, et c'est le cas pour l'utilisation d'électrodes dans la réalisation de biopiles ou de biocapteurs, on choisira une longueur très courte, les longueurs desdites électrodes ne dépassent pas par exemple 5cm, 1 à 3cm de préférence. Il s'agit de microélectrodes de 1 à 30 micromètres de diamètre et de 1 à 3cm de longueur qui peuvent être implantées sous la peau ou dans tout organisme vivant.

Un dépôt sélectif peut être fait sur les fibres. Chaque fibre ne sera alors recouverte que sur des tronçons de longueur prédéterminée. La réalisation d'électrodes à partir de ces fibres consiste à découper des tronçons de fibre de manière à avoir le dépôt (biopolymère et éventuellement polymère redox) uniquement à une extrémité du tronçon. De telles électrodes peuvent être utilisées dans la réalisation de sondes neurobiologiques par exemple.

Les fibres décrites dans la présente invention peuvent être utilisées sous formes de fils et rubans multifilamentaires, de mats, de structures tissées ou non tissées.

## Revendications

1. Fibres à conductivité électrique **caractérisées en ce qu'**elles sont constituées uniquement de nanotubes de carbone assemblés recouverts d'un dépôt comprenant au moins un biopolymère.

2. Fibres à conductivité électrique selon la revendication 1, **caractérisées en ce que** le biopolymère est choisi parmi les protéines naturelles ou de synthèse.

3. Fibres à conductivité électrique selon la revendication 2, **caractérisées en ce que** les protéines naturelles ou de synthèse, sont des enzymes.

4. Fibres à conductivité électrique selon la revendication 3, **caractérisées en ce que** le dépôt comprend en outre un ou plusieurs polymère(s) redox.

5. Fibres à conductivité électrique selon la revendication 1, **caractérisées en ce que** le biopolymère est choisi parmi les acides nucléiques par exemple l'ADN ou l'ARN.

6. Procédé de fabrication de fibres selon l'une quelconque des revendications 1 à 5, **caractérisé en ce qu'**il comprend les étapes suivantes :
- réalisation de fibres constituées uniquement de nanotubes de carbone,
- effectuer au moins un dépôt sur ces fibres comprenant au moins un biopolymère.

7. Procédé de fabrication de fibres selon la revendication 6, **caractérisé en ce que** la réalisation de fibres constituées de nanotubes de carbone comprend le filage de fibres obtenues par coagulation des nanotubes de carbone à partir d'une dispersion de nanotubes de carbones dans un solvant aqueux ou organique.

8. Procédé de fabrication de fibres selon la revendication 6, **caractérisé en ce qu'**il consiste à effectuer un dépôt sur les fibres comprenant en outre un ou plusieurs polymère(s) redox.

9. Procédé de fabrication de fibres selon la revendication 6, **caractérisé en ce que** le dépôt est effectué par trempage ou immersion des fibres dans une solution contenant au moins un biopolymère, ou par électrodéposition ou encore par déposition (badigeonnage ou pulvérisation).

10. Procédé de fabrication de fibres selon les revendications 8 et 9, **caractérisé en ce que** le dépôt du ou des polymère (s) redox est effectué en même temps que le dépôt du ou des biopolymère(s).

11. Procédé de fabrication de fibres selon la revendication 8, **caractérisé en ce que** le dépôt du ou des polymère(s) redox est effectué avant le dépôt du ou des biopolymère(s).

12. Procédé de fabrication de fibres selon la revendication 6, **caractérisé en ce que** le dépôt est effectué sur des tronçons sélectionnés de fibres par déposition (badigeonnage ou pulvérisation).

13. Procédé de fabrication de fibres selon la revendication 7, selon lequel la coagulation des nanotubes comporte l'utilisation d'un liant, **caractérisé en ce qu'**il comprend également une étape de retrait du liant avant la ou les étapes de dépôt.

14. Procédé de fabrication des fibres selon la revendication 13, **caractérisé en ce que** le retrait du liant consiste à chauffer les fibres à la température de fusion du liant.

15. Procédé de fabrication des fibres selon la revendication 13 ou 14, **caractérisé en ce que** le liant utilisé est de l'alcool polyvinylique (APV) et le chauffage des fibres est réalisé entre 300°C et 1100 °C et de préférence à 600°C sous atmosphère inerte.

16. Utilisation de fibres selon l'une quelconque des revendications 1 à 5, sous forme de fils et rubans multifilamentaires, de mats, de structures tissées ou non tissées.

17. Electrodes, **caractérisées en ce qu'**elles sont réalisées en fibre de nanotubes de carbone, selon l'une quelconque des revendications 1 à 5 et 16.

18. Electrodes selon la revendication 17, **caractérisées en ce qu'**elles sont constituées d'un tronçon de fibre de longueur inférieure ou égale à 5, de préférence compris entre 1 et 3cm et dont le diamètre peut aller de 1 à 30 micromètres.

19. Electrodes selon la revendication 10 et 17, **caractérisées en ce qu'**elles sont constituées d'un tronçon de fibre dont une extrémité seulement comporte un dépôt.

20. Utilisation des électrodes telles que définies selon l'une des revendications 17 à 19, dans la réalisation de systèmes bioélectrochimiques.

21. Utilisation des électrodes telles que définies selon l'une des revendications 17 à 19 dans la réalisation de biopiles ou de biocapteurs.

22. Utilisation des électrodes telles que définies selon l'une des revendications 17 à 19 dans la réalisation de biopiles ou de biocapteurs à usage biomédicaux.

## Patentansprüche

1. Fasern mit elektrischer Leitfähigkeit, **dadurch gekennzeichnet, dass** sie ausschließlich aus zusammengefügten Kohlenstoff-Nanoröhren bestehen, die mit einem Überzug umhüllt sind, der mindestens ein Biopolymer umfasst.

2. Fasern mit elektrischer Leitfähigkeit nach Anspruch 1, **dadurch gekennzeichnet, dass** das Biopolymer ausgewählt wird aus natürlichen oder synthetischen Proteinen.

3. Fasern mit elektrischer Leitfähigkeit nach Anspruch 2, **dadurch gekennzeichnet, dass** die natürlichen oder synthetischen Proteine Enzyme sind.

4. Fasern mit elektrischer Leitfähigkeit nach Anspruch 3, **dadurch gekennzeichnet, dass** der Überzug ferner ein oder mehrere Redox-Polymere umfasst.

5. Fasern mit elektrischer Leitfähigkeit nach Anspruch 1, **dadurch gekennzeichnet, dass** das Biopolymer ausgewählt wird aus Nukleinsäuren, beispielsweise DNA oder RNA.

6. Verfahren zur Herstellung von Fasern nach einem der Ansprüche 1 bis 5, **dadurch gekennzeichnet, dass** es die folgenden Schritte umfasst:
- Herstellen von Fasern, die ausschließlich aus Kohlenstoff-Nanoröhren bestehen,
- Aufbringen zumindest eines Überzugs auf diese Fasern, der zumindest ein Biopolymer umfasst.

7. Verfahren zur Herstellung von Fasern nach Anspruch 6, **dadurch gekennzeichnet, dass** das Herstellen der Fasern, die aus Kohlenstoff-Nanoröhren bestehen, das Spinnen von Fasern umfasst, die durch Koagulation der Kohlenstoff-Nanoröhren erzielt werden, ausgehend von einer Dispersion von Kohlenstoff-Nanoröhren in einem wässrigen oder organischen Lösungsmittel.

8. Verfahren zur Herstellung von Fasern nach Anspruch 6, **dadurch gekennzeichnet, dass** es darin besteht, einen Überzug auf den Fasern aufzubringen, der ferner einen oder mehrere Redox-Polymere umfasst.

9. Verfahren zur Herstellung von Fasern nach Anspruch 6, **dadurch gekennzeichnet, dass** der Überzug durch Eintauchen oder Untertauchen der Fasern in eine Lösung, die zumindest ein Biopolymer enthält, oder durch Galvanisierung oder durch Abscheidung (Bestreichen oder Zerstäuben) aufgebracht wird.

10. Verfahren zur Herstellung von Fasern nach den Ansprüchen 8 und 9, **dadurch gekennzeichnet, dass** der Überzug aus dem Redox-Polymer oder den Redox-Polymeren zur gleichen Zeit wie der Überzug aus dem Biopolymer oder den Biopolymeren aufgebracht wird.

11. Verfahren zur Herstellung von Fasern nach Anspruch 8, **dadurch gekennzeichnet, dass** der Überzug aus dem Redox-Polymer oder den Redox-Polymeren vor dem Überzug aus dem Biopolymer oder den Biopolymeren aufgebracht wird.

12. Verfahren zur Herstellung von Fasern nach Anspruch 6, **dadurch gekennzeichnet, dass** der Überzug auf ausgewählten Abschnitten der Fasern durch Abscheidung (Bestreichen oder Zerstäuben) aufgebracht wird.

13. Verfahren zur Herstellung von Fasern nach Anspruch 7, wobei die Koagulation der Nanoröhren die Verwendung eines Bindemittels umfasst, **dadurch gekennzeichnet, dass** er außerdem einen Schritt des Entfernens des Bindemittels vor dem Schritt oder den Schritten der Abscheidung umfasst.

14. Verfahren zur Herstellung von Fasern nach Anspruch 13, **dadurch gekennzeichnet, dass** das Entfernen des Bindemittels darin besteht, die Fasern auf die Schmelztemperatur des Bindemittels zu erwärmen.

15. Verfahren zur Herstellung von Fasern nach Anspruch 13 oder 14, **dadurch gekennzeichnet, dass** das verwendete Bindemittel Polyvinylalkohol (PVA) ist und die Erwärmung der Fasern unter Schutzgasatmosphäre auf zwischen 300 °C und 1100 °C und vorzugsweise auf 600 °C erfolgt.

16. Verwendung der Fasern nach einem der Ansprüche 1 bis 5 in Form von Fäden und mehrfädigen Bändern, Matten sowie gewebten oder nicht gewebten Strukturen.

17. Elektroden, **dadurch gekennzeichnet, dass** sie aus Fasern hergestellt werden, die aus Kohlenstoff-Nanoröhren bestehen, nach einem der Ansprüche 1 bis 5 und 16.

18. Elektroden nach Anspruch 17, **dadurch gekennzeichnet, dass** sie aus einem Faserabschnitt mit einer Länge von höchstens 5 und vorzugsweise zwischen 1 und 3 cm bestehen, dessen Durchmesser zwischen 1 und 30 Mikrometern betragen kann.

19. Elektroden nach Anspruch 10 und 17, **dadurch gekennzeichnet, dass** sie aus einem Faserabschnitt bestehen, von dem nur ein Ende einen Überzug aufweist.

20. Verwendung der Elektroden nach einem der Ansprüche 17 bis 19 in der Herstellung von bioelektrochemischen Systemen.

21. Verwendung der Elektroden nach einem der Ansprüche 17 bis 19 in der Herstellung von Biobatterien oder Biosensoren.

22. Verwendung der Elektroden nach einem der Ansprüche 17 bis 19 in der Herstellung von Biobatterien oder Biosensoren zur Biomedizinischen Verwendung.

## Claims

1. Electrically conductive fibers, **characterized in that** they consist only of assembled carbon nanotubes that are covered by a deposit that comprises at least one biopolymer.

2. Electrically conductive fibers according to claim 1, **characterized in that** the biopolymer is selected from among the natural or synthetic proteins.

3. Electrically conductive fibers according to claim 2, **characterized in that** the natural or synthetic proteins are enzymes.

4. Electrically conductive fibers according to claim 3, **characterized in that** the deposit further comprises one or more redox polymer(s).

5. Electrically conductive fibers according to claim 1, **characterized in that** the biopolymer is selected from among the nucleic acids, for example DNA or RNA.

6. Process for manufacturing fibers according to any one of claims 1 to 5, **characterized in that** it comprises the following stages:
- production of fibers that consist only of carbon nanotubes,
- making at least one deposit on these fibers that comprise at least one biopolymer.

7. Process for manufacturing fibers according to claim 6, **characterized in that** the production of fibers that consist of carbon nanotubes comprises the spinning of fibers obtained by coagulation of the carbon nanotubes from a dispersion of carbon nanotubes in an aqueous or organic solvent.

8. Process for manufacturing fibers according to claim 6, **characterized in that** it consists in making a deposit on the fibers that further comprise one or more redox polymer(s).

9. Process for manufacturing fibers according to claim 6, **characterized in that** the deposit is made by quenching or immersing the fibers in a solution that contains at least one biopolymer, or by electrodeposition or else by deposition (coating or spraying).

10. Process for manufacturing fibers according to claims 8 and 9, **characterized in that** the deposit of the redox polymer(s) is made at the same time as the deposit of the biopolymer(s).

11. Process for manufacturing fibers according to claim 8, **characterized in that** the deposit of the redox polymer(s) is made before the deposit of the biopolymer(s).

12. Process for manufacturing fibers according to claim 6, **characterized in that** the deposit is made on selected fiber segments by deposition (coating or spraying).

13. Process for manufacturing fibers according to claim 7, according to which the coagulation of the nanotubes comprises the use of a binder, **characterized in that** it also comprises a stage for removal of the binder before the deposition stage(s).

14. Process for manufacturing fibers according to claim 13, **characterized in that** the removal of the binder consists in heating the fibers to the melting point of the binder.

15. Process for manufacturing fibers according to claim 13 or 14, **characterized in that** the binder that is used is polyvinyl alcohol (PVA), and the heating of the fibers is done between 300°C and 1100°C, and preferably at 600°C under inert atmosphere.

16. Use of fibers according to any one of claims 1 to 5, in the form of wires and multifilament strips, mats, woven or non-woven structures.

17. Electrodes, **characterized in that** they are made of carbon nanotube fibers, according to any one of claims 1 to 5 and 16.

18. Electrodes according to claim 17, **characterized in that** they consist of a fiber segment with a length that is less than or equal to 5, preferably between 1 and 3 cm, and whose diameter can range from 1 to 30 micrometers.

19. Electrodes according to claim 10 and 17, **characterized in that** they consist of a fiber segment of which only one end comprises a deposit.

20. Use of the electrodes as defined according to one of claims 17 to 19, in the production of bioelectrochemical systems.

21. Use of the electrodes as defined according to one of claims 17 to 19, in the production of biobatteries or biosensors.

22. Use of the electrodes as defined according to one of claims 17 to 19, in the production of biobatteries or biosensors for biomedical use.
